# EUROPÄISCHE PATENTSCHRIFT

(11) **EP 1 931 184 B1**
(45) Veröffentlichungstag und Bekanntmachung des Hinweises auf die Patenterteilung: **24.11.2010**
(21) Anmeldenummer: 07023655.9
(22) Anmeldetag: 06.12.2007
(51) Int. Cl.: H05K 1/14

(54) **Leiterplatte**
Conductor board
Plaquette

(30) Priorität: 08.12.2006 DE 102006059392
(43) Veröffentlichungstag der Anmeldung: 11.06.2008
(73) Patentinhaber: Würth Elektronik Pforzheim GmbH & Co. KG, 75175 Pforzheim (DE)
(72) Erfinder: Dietrich, Frank, 73760 Ostfildern (DE)
(74) Vertreter: Schöndorf, Jürgen

(56) Entgegenhaltungen:
- US-A1- 2002 158 840
- US-A1- 2005 235 752
- US-A1- 2006 021 453
- US-A1- 2006 087 820
- US-B1- 6 675 663

## Beschreibung

Die Erfindung geht aus von einer Leiterplatte.

Zur Messung physikalischer Größen, wie beispielsweise Kraft, Druck oder Temperatur, sind Sensoren bekannt, die auch als kleine Einzelbauteile auf Leiterplatten montiert werden können. Sie können dort beispielsweise eingelötet werden. Sie sind dann in der Lage, die physikalischen Größen zu messen und als elektrischen Wert auszugeben. Die Leiterplatte muss diesen Messwert dann entsprechend weiterleiten, damit er in einer entsprechenden Auswerteschaltung weiterverarbeitet werden kann.

So gibt es beispielsweise Drucksensoren, die auf die Leiterplatte aufgelötet werden können.

Ebenfalls bekannt sind gekapselte Widerstände, die einen Temperaturkoeffizienten aufweisen.

Allen diesen in sich abgeschlossenen Sensoren ist gemeinsam, dass sie erst an einer Leiterplatte befestigt werden müssen, beispielsweise durch Löten oder durch Einstecken in Buchsen oder Stecksysteme.

Aufgrund der EMV-Anforderungen im Bereich der Elektronik ist es aber wünschenswert, mit möglichst wenig zusätzlichen Steck- oder Lötverbindungen auszukommen.

Ein bekannter Beschleunigungssensor (DE 19738358) ist als getrenntes Bauteil ausgebildet und kann auf einer Leiterplatte angebracht werden.

### (Einfügung Beginn)

Weiterhin bekannt ist das Einsetzen von Verformungssensoren innerhalb von Leiterplatten. Dabei sind in einer mehrlagigen Leiterplatte einzelne Dehnungsmessstreifen eingebettet (US 2006/0021453 A1). Ebenfalls bekannt ist ein Koordinateneingabegerät mit einer Leiterplatte nach dem Oberbegriff des Anspruchs 1 (US 2002/0158840 A1). Dort ist ein Bereich einer Leiterplatte dadurch abgegrenzt, dass er von vier rechtwinklig verlaufenden Schnitten umgeben ist, so dass ein mittlerer Bereich gebildet ist, der nach Art einer Kreuzung an allen seinen Seiten mit der Leiterplatte verbunden ist. Die Verformung dieses mittleren Bereichs kann gemessen werden.

Weiterhin bekannt ist ein Drucksensor, der eine Membran und ein Messelement zum messen der Verformung der Membran enthält (US 2095/0235702 A1).

Weiterhin bekannt ist ein Gerät, das in einer Brückenschaltung in Dickschichttechnologie gedruckte Dehnungsmessstreifen aufweist (US 6675663 B1).

### (Einfügung Ende)

Der Erfindung liegt die Aufgabe zu Grunde, eine Möglichkeit zu schaffen, die Messung von physikalischen Größen im Hinblick auf einen vereinfachten Aufbau, die Einsparung von Platz und Gewicht und die Vermeidung von EMV Störungen zu verbessern.

Zur Lösung dieser Aufgabe schlägt die Erfindung eine Leiterplatte mit den im Anspruch 1 genannten Merkmalen vor. Weiterbildungen der Erfindung sind Gegenstand von abhängigen Patentansprüchen.

Die Erfindung schlägt also vor, in einer Leiterplatte einen Sensorbereich zu definieren, der unabhängig von dem Rest der Leiterplatte verformbar ist. Diese mechanische Verformung wird dann mithilfe elektrischer Größen gemessen. Auf diese Weise kann die Verformung, die durch die zu messende Größe direkt oder indirekt verursacht wird, dazu herangezogen werden, den Wert der zu messenden Größe zu bestimmen.

Um den Grad der Verformung zu messen, kann erfindungsgemäß beispielsweise vorgesehen sein, dass die Schaltung mindestens einen in dem Sensorbereich angeordneten Widerstand aufweist, der so ausgebildet ist, dass er sich bei der Verformung des Sensorbereichs mitverformt und dadurch seinen Widerstandswert ändert. Solche Widerstände stehen als Dehnungsmessstreifen zur Verfügung. Es sind aber auch andere Möglichkeiten gegeben, einen Widerstand mit dem Sensorbereich so zu verbinden, dass er sich mit diesem verformt.

Eine der Möglichkeiten, einen solchen Widerstand mit dem Sensorbereich zu verbinden, besteht darin, den Widerstand im Dickschichtverfahren aufzutragen, also beispielsweise durch ein Siebdruckverfahren.

Um die Verformung möglichst genau und damit auch sicher zu messen, kann erfindungsgemäß in Weiterbildung vorgesehen sein, dass der Widerstand Teil einer Wheatstonebrücke ist. Auf diese Weise ist es möglich, auch sehr kleine Veränderungen des Widerstands zu entdecken und bei Verwendung des gleichen Widerstandsmaterials auf dem gleichen Substrat eine weit gehende Temperaturkompensation zu gewährleisten.

Bei einer Verformung des Sensorbereichs gibt es Zonen, die gedehnt werden, und Zonen, die gestaucht werden. Die Erfindung schlägt vor, mindestens einen Widerstand in der Zugzone anzuordnen, insbesondere dann, wenn bei einer Zugbelastung des verwendeten Widerstandsmaterials eine deutliche Änderung des Widerstandswerts gegeben ist.

Es ist aber ebenfalls vorgesehen, dass mindestens ein Widerstand in der Druckzone des Sensorbereichs angeordnet werden kann.

Eine Möglichkeit, wie man einen Sensorbereich bilden kann, besteht darin, dass dieser einen aus der Leiterplatte ausgefrästen Biegebalken aufweist, der mit dem Rest der Leiterplatte über eine Anlenkstelle verbunden bleibt.

Dieser Biegebalken verformt sich bei einer mechanischen Beaufschlagung. Die Größe und das Ausmaß der Verformung hängt natürlich von den einwirkenden Kräften ab. Je nach den zu erwartenden Kräften ist es möglich, den Biegebalken mehr oder weniger stark verbiegbar auszubilden. Dies kann durch die Breite und die Länge des Biegebalkens erreicht werden.

Eine weitere Möglichkeit besteht darin, die Anlenkstelle entsprechend zu gestalten. So kann man aus Gründen der einfachen Herstellung beispielsweise der Anlenkstelle die gleiche Breite geben wie dem Biegebalken selbst. Er ist dann allseits von einem U-förmigen Schnitt umgeben, dessen Schenkel parallel zueinander verlaufen.

Es ist aber ebenfalls möglich und liegt im Rahmen der Erfindung, die Breite der Anlenkstelle kleiner als die Breite des Biegebalkens zu machen. Dann kann man eine stärkere Verformung erreichen.

Insbesondere kann vorgesehen sein, als Material für den Widerstand ein Material mit einem hohen Gauge-Faktor zu verwenden.

Hierbei kann es sich beispielsweise um eine Widerstandspaste aus den in diesem Bereich üblichen Materialien handeln.

Wenn mit dem Sensorbereich eine Temperatur ermittelt werden soll, kann in Weiterbildung der Erfindung vorgesehen sein, dass mit dem Biegebalken ein Materialstreifen zugfest und druckfest verbunden wird, der einen von dem Material des Biegebalkens unterschiedlichen thermischen Ausdehnungskoeffizienten aufweist. In diesem Fall führt eine Temperaturänderung zu einer Verbiegung des Biegebalkens, die dann gemessen werden kann.

Es wurde bereits daraufhingewiesen, dass je nach den zu erwartenden Verformungen der Biegebalken entsprechend gestaltet werden muss. Es kann beispielsweise auch erforderlich oder sinnvoll sein, den Biegebalken dadurch mechanisch zu verstärken, dass man ihn mit einem Materialstreifen versieht, der den gleichen Ausdehnungskoeffizienten aufweist wie der Biegebalken selbst.

Eine weitere Möglichkeit, wie man die Erfindung zur Messung einer physikalischen Größe verwenden kann, besteht darin, auf der Leiterplatte ein Messmodul zu befestigen, das mit einem mechanisch beaufschlagenden Element an dem verformbaren Bereich der Leiterplatte angreift. Beispielsweise kann das Messmodul zur Messung eines Drucks ausgebildet sein und in seinem Inneren eine durch den zu messenden Druck verformbare Membran aufweisen. Diese Membranen kann dann mit einem Stößel wirkverbunden sein, der auf den Sensorbereich mechanisch einwirkt.

Es gibt eine Vielzahl von derartigen Messmodulen, die einen physikalischen Wert in eine mechanische Beaufschlagung umsetzen können. Die Ermittlung des Messwerts geschieht dann immer durch die Verformung des Sensorbereichs, zu dessen Aussetzung immer die gleiche Schaltung verwendet werden kann. Beispielsweise ist es auch möglich, einen Signalverstärker zur Erzeugung eines normierten Signals zu verwenden.

Die Leiterplatte kann beispielsweise ausschließlich zur Messwerterzeugung verwendet werden. Es ist aber auch möglich, dass der Sensorbereich in einer Leiterplatte vorhanden ist, die auch andere Aufgaben übernimmt.

Falls die physikalischen Größen, die gemessen werden sollen, nur kleine Auswirkungen haben, kann erfindungsgemäß vorgesehen sein, dass die Leiterplatte mehrere Sensorbereiche für die Messung der gleichen physikalischen Größe aufweist. Diese mehreren Sensorbereiche können dann zur Vergrößerung der Empfindlichkeit oder zur Vergrößerung der Genauigkeit verwendet werden.

Es ist ebenfalls möglich und wird von der Erfindung vorgeschlagen, dass die Leiterplatte mehrere Sensorbereiche für die gleiche Größe, aber für unterschiedliche Messbereiche aufweist. Dadurch lässt sich der gesamte Messbereich, für den die Leiterplatte verwendbar ist, vergrößern.

Natürlich ist es auch möglich und wird von der Erfindung vorgeschlagen, dass die Leiterplatte mehrere Sensorbereiche für die Messung verschiedener physikalischer Größen aufweist.

Eine der Möglichkeiten, wie der Sensorbereich aufgebaut sein kann, wurde bereits erwähnt. Es gibt aber auch die Möglichkeit, den Sensorbereich beispielsweise als Membran auszubilden, also keinen frei kragenden Balken, sondern eine Verformung nach Art einer Membran.

Insbesondere kann vorgesehen sein, dass die Leiterplatte in einer Multilayertechnologie hergestellt ist, und dass eine freigestellter Layer aus biegsamem Material die Membran bildet. Diese kann dabei vorzugsweise kreisrund ausgebildet sein. Widerstände können dabei beispielsweise im Randbereich angeordnet werden, also an der Stelle, wo die Membran eingespannt ist.

Ebenfalls vorgesehen sein kann, dass der Sensorbereich einen unverformbaren Bereich aufweist, der allseits von einem Streifen aus biegsamem Material umgeben ist, wobei die zu messende Größe an dem unverformbaren Bereich angreift und die Verformung auf den diesen umgebenden Streifen beschränkt wird.

Neben den bisher erwähnten Möglichkeiten, bei denen die Verformung so auftritt, dass ein Teil der Leiterplatte aus der Fläche der Leiterplatte heraus bewegt wird, gibt es erfindungsgemäß auch die Möglichkeit, einen Bereich der Leiterplatte so auszubilden, dass er in der Ebene der Leiterplatte liegend verformt wird. Beispielsweise kann ein solcher Bereich als Torsionsbalken ausgebildet sein. Mithilfe eines solchen Torsionsbalkens, der ein größeres Rückstellmoment erzeugt, kann beispielsweise ein Drehmoment gemessen werden.

Erfindungsgemäß kann ebenfalls vorgesehen sein, einen verformbaren Bereich mit einem Gewicht zu versehen und auf diese Weise eine Verstärkung eines Ausschlags durch die auf das Gewicht einwirkende Schwerkraft zu bewirken. Beispielsweise kann eine Leiterplatte mit einem Biegebalken so angeordnet werden, dass das freie Ende des Biegebalkens nach unten zeigt. Wenn nun die Leiterplatte aus einer senkrechten Stellung geneigt wird, bleibt, verstärkt durch das Gewicht, der Biegebalken senkrecht, so dass die Verformung abhängig von dem Grad der Neigung der Leiterplatte wird. Eine solche Leiterplatte kann als Inklinometer verwendet werden.

In Weiterbildung der Erfindung kann vorgesehen sein, dass der aufgebrachte Widerstand als Polymer- Dickschicht- Dehnungsmessstreifen ausgebildet ist. Im Unterschied zu herkömmlichen Dehnungsmessstreifen besitzt eine solche Ausbildung die Fähigkeit, größere Durchbiegungen zu messen. Dies bedeutet, dass der strukturierte Biegebalken zur Signalgenerierung Wege von 0,5 mm bis 5 mm je nach Leiterplattendicke und Biegebalkenlänge durchführt. Dieser Effekt kann zur Wegmessung von kurzen Wegen genutzt werden.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: eine schematische Draufsicht auf eine Leiterplatte mit einem Sensorbereich;
- Figur 2: schematisch eine Auswerteschaltung für den Sensorbereich;
- Figur 3: einen schematischen Längsschnitt durch die Leiterplatte der Figur 1;
- Figur 4: einen der Figur 3 entsprechenden Schnitt bei einer geänderten Ausführungsform;
- Figur 5: einen Schnitt durch eine Leiterplatte mit einem Drucksensor.
- Figur 6: einen Schnitt durch eine Leiterplatte für eine Druckmessung;
- Figur 7: schematisch die Draufsicht auf den Sensorbereich der Figur 6;
- Figur 8: eine annähernd senkrecht angeordnete Leiterplatte mit einem Gewicht;
- Figur 9: eine Draufsicht auf eine Leiterplatte zum Messen eines Dreh- momentes und
- Figur 10: eine der Figur 5 und 6 entsprechende Darstellung einer Leiter- platte zur Messung eines Drehwinkels.

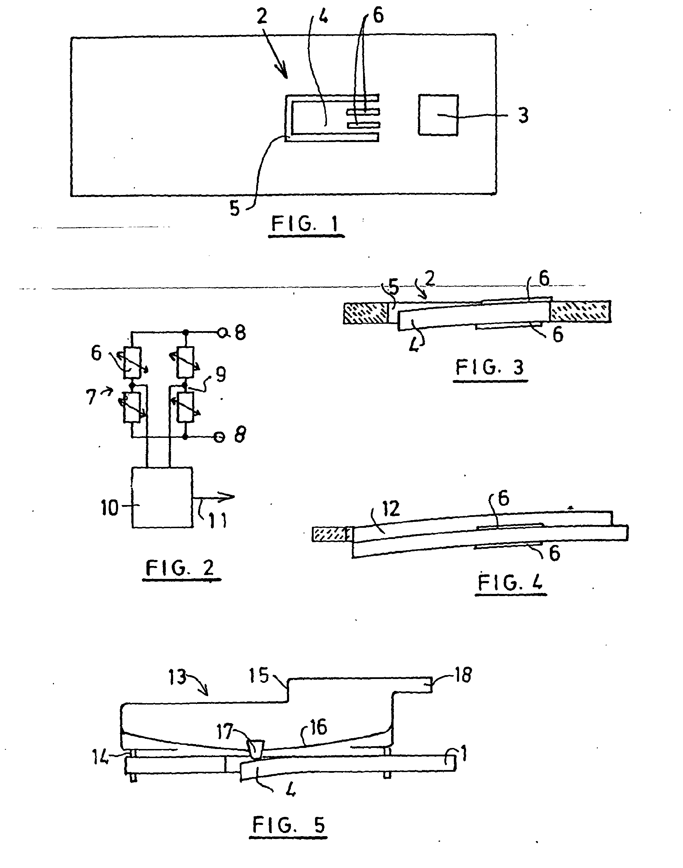

Figur 1 zeigt ganz vereinfacht eine Draufsicht auf eine Leiterplatte 1, in der ein Sensorbereich 2 angeordnet ist. Zusätzlich zu dem Sensorbereich 2 gibt es eine angedeutete Schaltung 3 zur Auswertung der Werte des Sensorbereichs. Der Sensorbereich 2 enthält einen Biegebalken 4, der dadurch entstanden ist, dass ein rechteckiger Teil der Leiterplatte durch einen U-förmigen Schlitz 5 ausgefräst ist. An dem einen Ende, in Figur 1 rechts, also dem Steg des Schlitzes 5 gegenüberliegend, ist dieser Biegebalken 4 mit der Leiterplatte 1 verbunden. Er kann also gegenüber der Zeichnungsebene nach oben und nach unten verbogen werden, ohne dass die Leiterplatte selbst verbogen wird. Auf der in Figur 1 zu sehenden Seite sind auf dem Biegebalken 4 im dem unmittelbar an die Verbindungsstelle heranreichenden Bereich zwei Widerstände 6 aufgebracht, die langgestreckt ausgebildet sind und die, wenn sich der Biegebalken 4 verbiegt, ebenfalls verbogen werden.

Figur 2 zeigt schematisch die Auswertungseinrichtungen für den Sensorbereich 2. Es handelt sich um eine Wheatstonebrücke 7 mit vier Widerständen 6, von denen beispielsweise zwei auf der Oberseite und zwei auf der Unterseite des Sensorbereichs angebracht sind. An die Eingangsklemmen 8 dieser Schaltung wird eine Gleichspannung angelegt, und an den jeweils zwei Widerstände verbindenden Schaltungspunkten 9 wird die Spannung gemessen und einem Signalverstärker 10 zugeführt, der auf einem Ausgang 11 ein normiertes Signal abgibt.

Figur 3 zeigt einen Längsschnitt durch den Sensorbereich 2 der Figur 1 bei einer Verformung des Biegebalkens 4 nach unten. Aufgrund des den Biegebalken umgebenden Frässchnitts 5 ist dieser Biegebalken 4 innerhalb des Ausschnitts in beide Richtungen verbiegbar.

Der insoweit beschriebenen Sensorbereich 2 der Leiterplatte 1 ist damit schon funktionsfähig. Er könnte zum Beispiel ohne zusätzliche Einrichtungen jetzt als Beschleunigungs- oder auch als Vibrationsmessgerät verwendet werden. Bei einer Vibration der Leiterplatte in einem Gehäuse kann sich der Biegebalken 4 im Takte der Vibrationen nach oben und unten verformen. Die dadurch bewirkte Verformung der Widerstände 6 auf der Oberseite und der Unterseite führt zu einer Änderung des Signals, das der Signalverstärker 10 auf der Leitung 11 abgibt.

Figur 4 zeigt eine ähnliche Einrichtung. Hier ist mit dem Biegebalken 4, der wiederum auf seiner Unterseite und seiner Oberseite jeweils einen mitverformten Widerstand 6 aufweist, ein Streifen 12 zugfest und druckfest angebracht. Dieser Streifen 12 weist einen anderen thermischen Ausdehnungskoeffizienten auf als das Material des Biegebalkens 4. Wegen der zugfesten und druckfesten Verbindung führt dies dazu, dass bei einer Temperaturänderung eine Verformung des Biegebalkens 4 auftritt. Auf diese Weise lässt sich mit ganz einfachen Mitteln eine Temperaturmessung durchführen.

Es gibt natürlich auch andere Möglichkeiten, wie der Biegebalken verformt werden kann. Eine solche Möglichkeit ist in Figur 5 angedeutet. Hier ist eine Druckmessdose 13 auf der Leiterplatte 1 befestigt. Die Befestigung geschieht mit Füßen 14 außerhalb des Sensorbereichs 4. In dem Gehäuse 15 der Druckmessdose 13 ist eine großflächige Membran 16 angeordnet, die in der Mitte mit einem Stößel 17 verbunden ist. Rechts ist ein Anschluss 18 für einen Schlauch dargestellt. Der zu messende Druck wird über den Schlauch und den Anschluss 18 in das Innere der Druckmessdose 13 geleitet. Je nach dem dort herrschenden Druck verformt sich die Membran 16 mehr oder weniger weit. Der mit der Membran 16 verbundene Stößel 17 beaufschlagt das freie Ende des Biegebalkens 4 und verformt ihn mehr oder weniger weit, je nach der Größe des Drucks. Die Größe der Verformung wird dann wiederum mit der in Figur 2 angedeuteten Schaltung gemessen.

Mit anderen Worten wird es mit einer solchen Leiterplatte möglich, physikalische Größen, die sich mit einfachen Mitteln in eine mechanische Beaufschlagung umsetzen lassen, elektrisch zu messen. Es spielt für den Aufbau der Leiterplatte und des Sensorbereichs sowie für die Auswerteschaltung im Prinzip keine Rolle, welche Art von physikalischer Größe und mit welcher Einrichtung in die Leiterplatte eingekoppelt wird. Eine derartige Leiterplatte ist also sehr vielseitig verwendbar.

In Figur 1 ist als einfaches Beispiel ein rechteckiger Biegebalken dargestellt. Je nach der zu erwartenden auf den Biegebalken einwirkenden Kraft und dem Material der Leiterplatte gibt es unterschiedliche Möglichkeiten, um zu verhindern, dass sich der Biegebalken zu stark oder zu wenig verformt. Man kann ihn unterschiedlich breit machen oder unterschiedlich lang. Man kann auch die Anlenkstelle schmaler machen, wenn man eine größere Verformung haben will. Die Widerstände 6 werden vorzugsweise in dem Bereich aufgebracht, wo die größte Verformung im Sinne einer Streckung oder Stauchung auftritt. Dies ist bei einem solchen Biegebalken in der Regel an der Stelle, wo der Biegebalken in die Leiterplatte 1 übergeht.

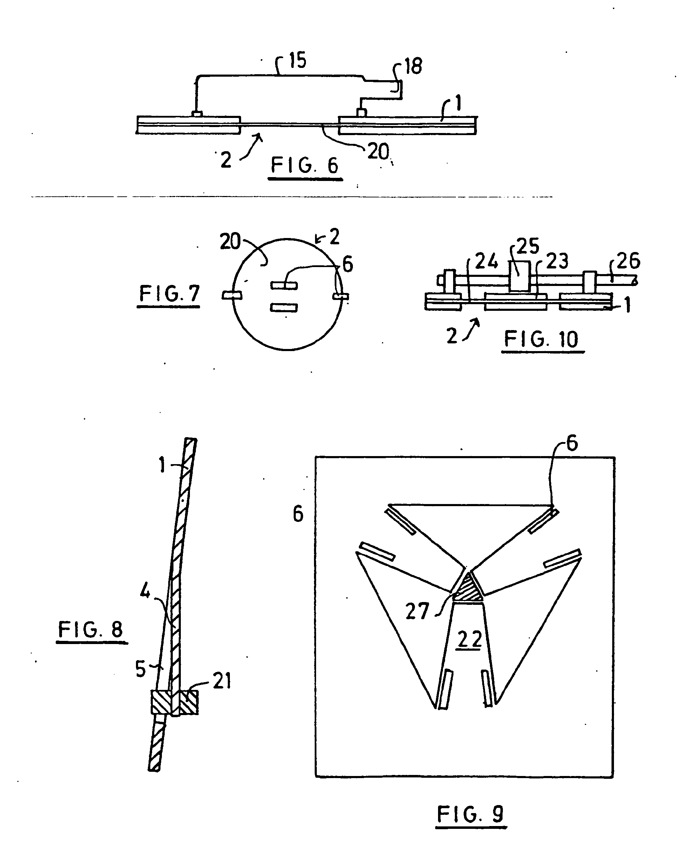

Nun zu Figur 6. Während die Ausführungsform der Figur 5 zur Messung eines Drucks eine in dem Messmodul angeordnete Membran 16 verwendet, zeigt die Figur 6 eine Ausführungsform einer Leiterplatte, bei der ein Teil der Leiterplatte selbst als Membran 20 ausgebildet ist. Die Leiterplatte 1 ist als Multilayerleiterplatte ausgebildet, enthält also mehrere Schichten, von denen eine Schicht, beispielsweise die mittlere Schicht, aus einem biegsamen Material besteht. Die äußeren härteren Schichten sind an der Stelle des Sensorbereichs 2 freigestellt, so dass die verformbare Schicht in Form eines Kreises als Membran wirken kann. Auf die eine Seite der Leiterplatte ist abgedichtet ein Gehäuse 15 aufgesetzt und befestigt, das einen Anschluss 18 für einen Schlauch aufweist. Der Druck innerhalb des Gehäuses 15 wirkt dann direkt auf die Membran 20 ein. Die Widerstände 6, siehe Figur 7, sind zum Teil auf der Membran 20 in deren Mitte und zum Teil im Einspannbereich der Membran aufgedruckt.

Figur 8 zeigt eine der Ausführungsform nach Figur 1 ähnliche Anordnung, bei dem ein Biegebalken 4 auf drei Seiten von einem U-förmigen Schlitz 5 umgeben ist. An dem der Anlenkstelle des Biegebalkens 4 abgewandten Ende ist dieser mit einem Gewicht 21 versehen. Die Leiterplatte 21 ist annähernd senkrecht so aufgestellt, dass die Anlenkstelle des Biegebalkens 4 oben und das mit dem Gewicht 21 versehene freie Ende des Biegebalkens 4 unten liegt. Aufgrund des Gewichts stellt sich der Biegebalken 4, da das Gewicht 21 am unteren Ende angeordnet ist, senkrecht. Mithilfe dieses durch den Biegebalken verwirklichten Pendels lässt sich die Neigung der Leiterplatte gegenüber einer Senkrechten in einem gewissen Bereich ermitteln. Diese Anordnung der Leiterplatte kann als Inklinometer dienen.

Figur 9 zeigt eine weitere Ausführungsform, bei der durch Einschnitte in der Leiterplatte 1 im dargestellten Beispiel drei nach innen gerichtete Bereiche der Leiterplatte gebildet werden. Diese sind in Form jeweils eines Trapezes ausgebildet. In dem durch die freien Kanten der drei verformbaren Bereiche gebildeten Raum ist eine Stange 27 mit einem dreieckigen Querschnitt angeordnet, der so ausgebildet ist, dass seine Seiten an den freien Kanten der als Torsionsbalken 22 wirkenden Bereiche der Leiterplatte 1 angreifen. In diesem Fall erfolgt, wenn die Stange verdreht wird, eine Verformung der Torsionsbalken in der Ebene der Leiterplatte. Da mit zunehmendender Verformung der Torsionsbalken 22 die durch die Verformung bewirkte Rückstellkraft der Torsionsbalken 22 zunimmt, bildet die Messung der Verformung eine Möglichkeit zur Messung eines Drehmomentes.

In Figur 10 ist in dem Sensorbereich 2 ein mittlerer Teil 23 einer Multilayerleiterplatte angeordnet, der allseits von einem Streifen 24 aus der mittleren verformbaren Schicht der Leiterplatte umgeben ist. Damit kann der mittlere Teil 23 aus der Ebene der Leiterplatte 1 nach unten oder nach oben heraus bewegt werden, wobei die Verformung auf den ihn umgebenden Streifen 24 beschränkt ist. Im dargestellten Beispiel ist auf der Leiterplatte 1 außerhalb des Sensorbereichs 2 eine Welle 26 drehgelagert, die in ihrem mittleren Bereich, entsprechend dem bewegbaren Teil 23 des Sensorbereichs 2, einen Nocken 25 aufweist. Auf diese Weise lässt sich durch Verdrehen der Stange 26 bei entsprechender Ausgestaltung der Nockenoberfläche ein Drehwinkel messen.

## Patentansprüche

1. Leiterplatte, mit
1.1 mindestens einem abgegrenzten Sensorbereich (2),
1.2 der gegenüber dem Rest der Leiterplatte (1) unabhängig von dieser verformbar ausgebildet ist und
1.3 einer zu messenden Größe direkt oder indirekt ausgesetzt ist, sowie mit
1.4 einer mindestens teilweise auf der Leiterplatte (1) angeordneten Schaltung (3) zur Messung des Grades und/oder der Richtung der Verformung des Sensorbereichs (2) mithilfe elektrischer Größen
**dadurch gekennzeichnet, dass**
1.5 mindestens ein Sensorbereich (2) einen aus der Leiterplatte (1) ausgefrästen auf drei Seiten nicht mit der Leiterplatte (1) verbundenen Biegebalken (4) und/oder mindestens einen auf drei Seiten nicht mit der Leiterplatte (1) verbundenen, in der Ebene der Leiterplatte (1) verformbaren Torsionsbalken (22) aufweist, der/die mit dem Rest der Leiterplatte (1) über eine Anlenkstelle verbunden bleibt/bleiben.

2. Leiterplatte nach Anspruch 1, bei der die Schaltung mindestens einen in dem Sensorbereich (2) angeordneten Widerstand (6) mit einem bei mechanischer Verformung sich ändernden Widerstandwert aufweist.

3. Leiterplatte nach Anspruch 2, bei der der Widerstand (6) im Dickschichtverfahren aufgetragen ist.

4. Leiterplatte nach Anspruch 2 oder 3, bei der der Widerstand (6) Teil einer Wheatstonebrücke (7) ist.

5. Leiterplatte nach einem der Ansprüche 2 bis 4, bei der mindestens ein Widerstand (6) in der Zugzone des Sensorbereichs (2) angeordnet ist.

6. Leiterplatte nach einem der Ansprüche 2 bis 5, bei der mindestens ein Widerstand (6) in der Druckzone des Sensorbereichs (2) angeordnet ist.

7. Leiterplatte nach einem der vorhergehenden Ansprüche, bei der die Breite der Anlenkstelle mit der Breite des Biegebalkens (4) identisch ist.

8. Leiterplatte nach einem der Ansprüche 1-6, bei der die Breite der Anlenkstelle kleiner ist als die Breite des Biegebalkens (4).

9. Leiterplatte nach einem der Ansprüche 3 bis 8, bei der das Material des Widerstands (6) einen hohen Gauge-Faktor aufweist.

10. Leiterplatte nach einem der vorhergehenden Ansprüche, bei der mit dem Biegebalken (4) ein Materialstreifen (12) mit einem unterschiedlichen thermischen Ausdehnungskoeffizienten zugfest und druckfest verbunden ist.

11. Leiterplatte nach einem der vorhergehenden Ansprüche, bei der der Biegebalken (4) mechanisch verstärkt ist.

12. Leiterplatte nach einem der vorhergehenden Ansprüche, mit einem auf ihr befestigten Messmodul, das einen Stößel (17) zum mechanischen Angriff an dem Sensorbereich (2) zu dessen Verformung aufweist.

13. Leiterplatte nach einem der vorhergehenden Ansprüche, mit einem Signalverstärker (10) zur Erzeugung eines normierten Signals.

14. Leiterplatte nach Anspruch 12 oder 13, bei der das Messmodul eine einem zu messenden Druck ausgesetzte Membran (16) aufweist, die mit dem Stößel (17) wirkverbunden ist.

15. Leiterplatte nach einem der vorhergehenden Ansprüche, mit weiteren elektrischen und/oder mechanischen Bauteilen.

16. Leiterplatte nach einem der vorhergehenden Ansprüche, mit mehreren Sensorbereichen (2) für die Messung der gleichen physikalischen Größe.

17. Leiterplatte nach Anspruch 16, bei der die mehreren Sensorbereiche (2) zur Vergrößerung der Empfindlichkeit und/oder zur Vergrößerung der Genauigkeit vorgesehen sind.

18. Leiterplatte nach Anspruch 16, bei dem die mehreren Sensorbereiche (2) für unterschiedliche Messbereiche vorgesehen sind.

19. Leiterplatte nach einem der vorhergehenden Ansprüche, mit mehreren Sensorbereichen (2) für die Messung unterschiedlicher physikalischer Größen.

20. Leiterplatte nach einem der Ansprüche 2 bis 19, mit mindestens einem außerhalb des Sensorbereichs (2) angeordneten Widerstand zur Temperaturkompensation und/oder zum Laserfunktionsabgleich für den Nullpunkt und die Verstärkung.

21. Leiterplatte nach einem der vorhergehenden Ansprüche, bei der mindestens ein Sensorbereich (2) als Membran (20) ausgebildet ist.

22. Leiterplatte nach Anspruch 21, bei der die Leiterplatte eine Multilayerleiterplatte ist und die Membran (20) von einer freigestellten Layer aus biegsamem Material gebildet ist, auf der die Widerstände (6) aufgebracht sind.

23. Leiterplatte nach einem der vorhergehenden Ansprüche, bei der der Sensorbereich (2) einen längs eines geschlossenen Wegs verlaufenden Bereich (24) aus nachgiebigem Material und einen von diesem verformbaren Bereich (24) umgebenen unverformbaren Bereich (23) aufweist, an dem die zu messende Größe angreift.

24. Leiterplatte nach einem der vorhergehenden Ansprüche, bei der ein Biegebalken (4) im Bereich seines freien Endes mit einem Gewicht (21) versehen ist.

25. Leiterplatte nach einem der vorhergehenden Ansprüche, insbesondere nach Anspruch 24, bei der die Leiterplatte angenähert senkrecht angeordnet ist.

26. Leiterplatte nach einem der Ansprüche 2 bis 25, bei der der Widerstand ein Polymer-Dickschicht- Dehnungsmessstreifen ist.

## Claims

1. Printed circuit board, comprising
1.1 at least one delimited sensor region (2),
1.2 which is embodied in a manner deformable relative to the rest of the printed circuit board (1) independently of the latter and
1.3 is exposed directly or indirectly to a variable to be measured, and also comprising
1.4 a circuit (3) arranged at least partly on the printed circuit board (1) and serving for measuring the degree and/or the direction of the deformation of the sensor region (2) with the aid of electrical variables, **characterized in that**
1.5 at least one sensor region (2) has a bending beam (4) milled out from the printed circuit board (1) and not connected to the printed circuit board (1) on three sides and/or at least one torsion beam (22) not connected to the printed circuit board (1) on three sides and deformable in the plane of the printed circuit board (1), which beam/beams remains/remain connected to the rest of the printed circuit board (1) via an articulated location.

2. Printed circuit board according to Claim 1, wherein the circuit has at least one resistor (6) arranged in the sensor region (2) and having a resistance that changes upon mechanical deformation.

3. Printed circuit board according to Claim 2, wherein the resistor (6) is applied by the thick-film method.

4. Printed circuit board according to Claim 2 or 3, wherein the resistor (6) is part of a Wheatstone bridge (7).

5. Printed circuit board according to any of Claims 2 to 4, wherein at least one resistor (6) is arranged in the tension zone of the sensor region (2).

6. Printed circuit board according to any of Claims 2 to 5, wherein at least one resistor (6) is arranged in the compression zone of the sensor region (2).

7. Printed circuit board according to any of the preceding claims, wherein the width of the articulated location is identical to the width of the bending beam (4).

8. Printed circuit board according to any of Claims 1-6, wherein the width of the articulated location is less than the width of the bending beam (4).

9. Printed circuit board according to any of Claims 3 to 8, wherein the material of the resistor (6) has a high gauge factor.

10. Printed circuit board according to any of the preceding claims, wherein a material strip (12) having a different coefficient of thermal expansion is connected to the bending beam (4) in a manner resistant to tensile stress and to compressive stress.

11. Printed circuit board according to any of the preceding claims, wherein the bending beam (4) is mechanically reinforced.

12. Printed circuit board according to any of the preceding claims, comprising a measuring module fixed thereon, said measuring module having a plunger (17) for mechanically acting on the sensor region (2) in order to deform the latter.

13. Printed circuit board according to any of the preceding claims, comprising a signal amplifier (10) for generating a normalized signal.

14. Printed circuit board according to Claim 12 or 13, wherein the measuring module has a membrane (16) exposed to a pressure to be measured, said membrane being operatively connected to the plunger (17).

15. Printed circuit board according to any of the preceding claims, comprising further electrical and/or mechanical components.

16. Printed circuit board according to any of the preceding claims, comprising a plurality of sensor regions (2) for the measurement of the same physical variable.

17. Printed circuit board according to Claim 16, wherein the plurality of sensor regions (2) are provided for increasing the sensitivity and/or for increasing the accuracy.

18. Printed circuit board according to Claim 16, wherein the plurality of sensor regions (2) are provided for different measurement ranges.

19. Printed circuit board according to any of the preceding claims, comprising a plurality of sensor regions (2) for the measurement of different physical variables.

20. Printed circuit board according to any of Claims 2 to 19, comprising at least one resistor arranged outside the sensor region (2) and serving for temperature compensation and/or for laser function adjustment for the zero point and the amplification.

21. Printed circuit board according to any of the preceding claims, wherein at least one sensor region (2) is embodied as a membrane (20).

22. Printed circuit board according to Claim 21, wherein the printed circuit board is a multilayer printed circuit board and the membrane (20) is formed by a freed layer of flexible material on which the resistors (6) are applied.

23. Printed circuit board according to any of the preceding claims, wherein the sensor region (2) has a region (24) composed of compliant material running along a closed path and a non-deformable region (23) surrounded by said deformable region (24), the variable to be measured acting on said non-deformable region.

24. Printed circuit board according to any of the preceding claims, wherein a bending beam (4) is provided with a weight (21) in the region of its free end.

25. Printed circuit board according to any of the preceding claims, in particular according to Claim 24, wherein the printed circuit board is arranged approximately perpendicularly.

26. Printed circuit board according to any of Claims 2 to 25, wherein the resistor is a polymer thick-film strain gauge.

## Revendications

1. Carte de circuit qui présente
1.1 au moins une plage délimitée de détection (2),
1.2 qui est formée indépendamment du reste de la carte de circuit (1) et qui peut être déformée par rapport à cette dernière et
1.3 qui est exposée directement ou indirectement à une grandeur à mesurer, et
1.4 un circuit (3) de mesure de l'ampleur et/ou de la direction de la déformation de la plage de détection (2) au moyen de grandeurs électriques, dont au moins une partie est disposée sur la carte de circuit (1),
**caractérisée en ce que**
1.5 au moins une plage de détection (2) présente une poutrelle de flexion (4) fraisée dans la carte de circuit (1), sur trois côtés non reliés à la carte de circuit (1) et/ou au moins une poutrelle de torsion (22), non reliée à la carte de circuit (1) sur trois côtés, déformable dans le plan de la carte de circuit (1) et qui reste reliée au reste de la carte de circuit (1) par un emplacement articulé.

2. Carte de circuit selon la revendication 1, dans laquelle le circuit présente au moins une résistance (6) disposée dans la plage de détection (2) et dont la valeur de la résistance varie en cas de déformation mécanique.

3. Carte de circuit selon la revendication 2, dans laquelle la résistance (6) est appliquée par un procédé d'application en couche épaisse.

4. Carte de circuit selon la revendication 2 ou 3, dans laquelle la résistance (6) fait partie d'un pont de Wheatstone (7).

5. Carte de circuit selon l'une des revendications 2 à 4, dans laquelle au moins une résistance (6) est disposée dans la zone de traction dans la plage de détection (2).

6. Carte de circuit selon l'une des revendications 2 à 5, dans laquelle au moins une résistance (6) est disposée dans la partie de compression de la plage de détection (2).

7. Carte de circuit selon l'une des revendications précédentes, dans laquelle la largeur de l'emplacement articulé est identique à la largeur de la poutre de flexion (4).

8. Carte de circuit selon l'une des revendications 1 à 6, dans laquelle la largeur de l'emplacement articulé est inférieure à la largeur de la poutre de flexion (4).

9. Carte de circuit selon l'une des revendications 3 à 8, dans laquelle le matériau de la résistance (6) présente un grand facteur de finesse.

10. Carte de circuit selon l'une des revendications précédentes, dans laquelle une bande de matière (12) dont le coefficient de dilatation thermique est différent est reliée à la poutre de flexion (4) à traction solidaire et à compression solidaire.

11. Carte de circuit selon l'une des revendications précédentes, dans laquelle la poutre de flexion (4) est renforcée mécaniquement.

12. Carte de circuit selon l'une des revendications précédentes, sur laquelle un module de mesure qui présente un poussoir (17) qui engage mécaniquement la plage de détection (2) pour la déformer est fixé.

13. Carte de circuit selon l'une des revendications précédentes, qui présente un amplificateur de signaux (10) qui forme un signal normalisé.

14. Carte de circuit selon la revendication 12 ou 13, **caractérisé en ce que** le module de mesure présente une membrane (16) exposée à la pression à mesurer et qui coopère avec le poussoir (17).

15. Carte de circuit selon l'une des revendications précédentes, qui présente des composants électriques et/ou d'autres composants mécaniques.

16. Carte de circuit selon l'une des revendications précédentes, qui présente plusieurs plages de détection (2) qui mesurent la même grandeur physique.

17. Carte de circuit selon la revendication 16, dans laquelle les différentes plages de détection (2) sont prévues pour augmenter la sensibilité et/ou augmenter la précision.

18. Carte de circuit selon la revendication 16, dans laquelle les différentes plages de détection (2) sont prévues pour différentes plages de mesure.

19. Carte de circuit selon l'une des revendications précédentes, qui présente plusieurs plages de détection (2) qui mesurent des grandeurs physiques différentes.

20. Carte de circuit selon l'une des revendications 2 à 19, qui présente au moins une résistance disposée à l'extérieur de la plage de détection (2) pour la compensation de la température et/ou pour équilibrer le fonctionnement du laser en termes de point zéro et d'amplification.

21. Carte de circuit selon l'une des revendications précédentes, dans laquelle au moins une plage de détection (2) est configurée comme membrane (20).

22. Carte de circuit selon la revendication 21, dans laquelle la carte de circuit est une carte multicouche et en ce que la membrane (20) est formée sur une couche dégagée en matériau flexible sur laquelle les résistances (6) sont appliquées.

23. Carte de circuit selon l'une des revendications précédentes, dans laquelle la plage de détection (2) présente une partie (24) en matériau déformable qui s'étend sur un parcours fermé et une partie (23) non déformable entourée par cette partie déformable (24) et sur laquelle est appliquée la grandeur à mesurer.

24. Carte de circuit selon l'une des revendications précédentes, dans laquelle l'extrémité libre d'une poutre de flexion (4) est dotée d'un poids (21).

25. Carte de circuit selon l'une des revendications précédentes, en particulier selon la revendication 24, dans laquelle la carte de circuit est disposée sensiblement à la verticale.

26. Carte de circuit selon l'une des revendications 2 à 25, dans laquelle la résistance est une bande de mesure d'allongement en couche polymère épaisse.
